Europäisches Patentamt

European Patent Office

Office européen des brevets

(11) Numéro de publication: **0 432 044 A1**

## (12) DEMANDE DE BREVET EUROPEEN

(21) Numéro de dépôt: 90403469.1

(22) Date de dépôt: 06.12.90

(51) Int. Cl.⁵: **H01L 23/36,** H01L 29/267, H01L 29/52, H01L 21/74, H01L 21/205

(30) Priorité: 08.12.89 FR 8916259

(43) Date de publication de la demande:
12.06.91 Bulletin 91/24

(84) Etats contractants désignés:
DE GB

(71) Demandeur: THOMSON-CSF
51, Esplanade du Général de Gaulle
F-92800 Puteaux(FR)

(72) Inventeur: Hirtz, Jean-Pierre
THOMSON-CSF, SCPI, Cédex 67
F-92045 Paris la Défense(FR)
Inventeur: Charasse, Marie-Noelle

THOMSON-CSF, SCPI, Cédex 67
F-92045 Paris la Défense(FR)
Inventeur: Pacou, Thierry
THOMSON-CSF, SCPI, Cédex 67
F-92045 Paris la Défense(FR)
Inventeur: Bosella, Alain
THOMSON-CSF, SCPI, Cédex 67
F-92045 Paris la Défense(FR)
Inventeur: Briere, Pierre
THOMSON-CSF, SCPI, Cédex 67
F-92045 Paris la Défense(FR)

(74) Mandataire: Ruellan-Lemonnier, Brigitte et al
THOMSON-CSF SCPI
F-92045 PARIS LA DEFENSE CEDEX 67(FR)

(54) **Perfectionnement aux transistors de puissance en matériaux III-V sur substrat silicium, et procédé de fabrication.**

(57) La présente invention concerne un transistor de puissance en matériaux de la famille III-V sur silicium du type comportant un substrat (1) en silicium, au moins une couche (3) de matériau III-V semi-isolant et une pluralité de couches (4,5) de matériau III-V dopées dans lesquelles est défini aux moins un canal conducteur muni d'une métallisation (6) de grille, chaque canal étant situé entre deux régions d'accès dites alternativement source et drain, munies chacune d'une métallisation (8,9), l'une des deux régions d'accès à un canal étant connectée électriquement et thermiquement avec le substrat en silicium.

Conformément à l'invention, le transistor comporte entre le substrat en silicium et la couche de matériau III-V semi-isolant, au moins une couche tampon (2) de silicium intrinsèque.

Application aux transistors de puissance en GaAs sur Si.

FIG.3

## PERFECTIONNEMENT AUX TRANSISTORS DE PUISSANCE EN MATERIAUX III-V SUR SUBSTRAT SILICIUM ET PROCEDE DE FABRICATION

La présente invention concerne un dispositif semi-conducteur de puissance réalisé en matériau de la famille III-V tel que GaAs sur un substrat en silicium ainsi qu'un procédé de fabrication d'un tel dispositif.

Pour réaliser des transistors fonctionnant à des fréquences millimétriques, il est connu d'utiliser des matériaux de la famille III-V tels que l'arséniure de gallium ou GaAs. Toutefois, si l'arséniure de gallium ou les matériaux similaires présentent de bonnes performances électriques, ces matériaux sont en fait mauvais conducteur thermique, ce qui limite leur emploi dans les transistors de puissance.

Pour remédier à ces inconvénients, on a pensé à réaliser des transistors sur une couche d'un matériau III-V, plus particulièrement de GaAs, que l'on fait croître sur un substrat de silicium. En effet, le silicium présente l'avantage d'être un meilleur conducteur thermique que l'arséniure de gallium et peut donc jouer le rôle d'un radiateur dissipant la chaleur.

Pour mettre en oeuvre cette propriété de conduction thermique du silicium, on a proposé dans la demande de brevet français N°88 13155 déposée par la Société Thomson Hybride et Microondes, de connecter l'une des régions d'accès au canal appelée source ou drain au substrat en silicium par l'intermédiaire d'un noyau métallique. Cette solution est particulièrement intéressante dans le cas des transistors de puissance. En effet, pour obtenir un transistor de puissance, il faut une largeur de grille suffisante. Toutefois, la largeur de grille est limitée par le déphasage dû au circuit RC formé par la résistance de grille et les capacités parasites grille-drain et grille-source, déphasage qui s'accentue aux fréquences élevées. Pour remédier à cet inconvénient, on a donc proposé une structure interdigitée. Cette structure interdigitée nécessite d'interconnecter les sources et/ou les drains. Ainsi, en utilisant les noyaux métalliques décrits dans le brevet français N°88 13155, il est possible de réaliser l'interconnexion des sources ou des drains en utilisant le substrat silicium qui peut être convenablement dopé pour être conducteur. Dans ce cas, le substrat en silicium sert à la fois de radiateur et d'interconnexion électrique.

Cette solution qui est bien maitrisée d'un point de vue technologique présente l'inconvénient d'introduire des capacités parasites grille-source ou drain-source qui limitent le fonctionnement des transistors à des fréquences inférieures à 10 GHz.

Ces capacités parasites sont dues à la trop faible épaisseur de la couche d'arséniure de gallium semi-isolante épitaxiée sur le substrat en silicium. Pour diminuer ces capacités, il faudrait une couche tampon semi-isolante beaucoup plus épaisse. Or, les progrès récents de l'épitaxie d'arséniure de gallium permettent d'obtenir des couches d'arséniure de gallium présentant des bonnes qualités cristallographiques dont l'épaisseur est d'au plus 6 $\mu$m sur un substrat en silicium. Pour des épaisseurs supérieures, l'arséniure de gallium présente de nombreux défauts et il est alors impossible de réaliser de bons circuits. D'autre part, l'utilisation d'une couche semi-isolante d'arséniure de gallium beaucoup plus épaisse n'est pas intéressante d'un point de vue thermique puisque l'arséniure de gallium est moins bon conducteur thermique que le silicium. Ainsi, plus on augmentera l'épaisseur de la couche semi-isolante d'arséniure de gallium, plus on augmentera la résistance thermique du transistor.

En conséquence, la présente invention a pour but de fournir un nouveau transistor de puissance en matériau de la famille III-V sur silicium permettant de remédier à ces inconvénients.

Ainsi, la présente invention a pour objet un transistor de puissance en matériaux de la famille III-V sur silicium du type comportant un substrat en silicium, au moins une couche de matériau III-V semi-isolant et une pluralité de couches de matériau III-V dopé dans lesquelles est défini aux moins un canal conducteur muni d'une métallisation de grille, chaque canal étant situé entre deux régions d'accès dites alternativement source et drain, munies chacune d'une métallisation, l'une des deux régions d'accès à un canal étant connectée électriquement et thermiquement avec le substrat en silicium, caractérisé en ce qu'il comporte entre le substrat en silicium et la couche de matériau III-V semi-isolant, au moins une couche tampon de silicium intrinsèque.

Cette nouvelle structure est très intéressante d'un point de vue thermique puisqu'elle permet l'évacuation des calories par le silicium. D'autre part, d'un point de vue électrique, les capacités parasites drain-source et grille-source sont réduites du fait de l'épaississement de la couche semi-isolante. En effet, la couche tampon de silicium présente une épaisseur supérieure ou égale à 10 $\mu$m alors que la couche de matériau III-V semi-isolant, à savoir la couche d'arséniure de gallium est typiquement de 4 $\mu$m. Une telle structure permet d'atteindre des fréquences d'au moins 12 GHz.

La présente invention concerne aussi différents procédés de fabrication d'un transistor de puissance du type ci-dessus.

Selon un premier procédé de fabrication, celui comporte les étapes suivantes :

- dépôt par épitaxie sur un substrat en silicium d'une couche tampon en silicium intrinsèque ;
- dépôt par épitaxie sur la couche tampon d'au moins une couche d'un matériau de la famille III-V semi-isolant ;
- réalisation de manière connue sur la couche en matériau semi-isolant d'un transistor de puissance contenant au moins un canal conducteur situé entre deux régions d'accès dite alternativement source et drain :
- réalisation d'au moins une ouverture dans la métallisation de prise de contact de l'une des deux régions d'accès, source ou drain :
- gravure, à travers cette ou ces ouvertures et au moyen d'un masque, des couches de matériau III-V et de silicium intrinsèque, la gravure s'arrêtant au contact du substrat en silicium ;
- dépôt, dans le fond du ou des puits obtenus, d'une couche métallique assurant un contact ohmique avec le substrat en silicium ;
- élimination du masque et
- recharge électrolytique du ou des puits en métal jusqu'à ce que le noyau métallique formé soit coplanaire avec la métallisation de la région dans laquelle il est formé.

Les transistors de puissance conformes à la présente invention peuvent être réalisés selon un autre procédé de fabrication qui consiste à réaliser les contacts ohmiques de source ou de drain sur le substrat en silicium avant l'épitaxie d'arséniure de gallium ou de matériaux III-V sur le substrat en silicium. Il est donc possible, dans ce cas, de réaliser un recuit à des températures supérieures à 450°C de manière à obtenir un bon contact ohmique.

Ce procédé de fabrication est caractérisé par les étapes suivantes :

- dépôt par épitaxie sur un substrat en silicium d'une couche tampon en silicium intrinsèque ;
- réalisation à l'aide d'un masque d'au moins une ouverture au niveau des futures électrodes d'un type des deux régions d'accès source ou drain ;
- gravure à travers cette ou ces ouvertures de la couche tampon en silicium intrinsèque, la gravure s'arrêtant au contact du substrat en silicium ;
- dépôt dans le fond du ou des puits obtenus, d'une couche métallique assurant un contact ohmique avec le substrat en silicium ;
- élimination du masque ;
- recharge électrolytique du ou des puits en métal jusqu'à ce que le noyau métallique formé soit coplanaire avec la couche tampon ;
- dépôt sur l'ensemble de la plaquette d'une couche de silice ;
- gravure, à travers un masque recouvrant les régions d'accès ci-dessus, de la couche de silice jusqu'au niveau de la couche tampon et élimination du masque ;
- dépôt par épitaxie sur l'ensemble de la plaquette, d'au moins une couche de matériau III-V semi-isolant donnant, au-dessus de la couche tampon, une couche de matériau III-V monocristalline ;
- réalisation, de manière connue, sur la couche monocristalline d'un transistor de puissance contenant au moins un canal conducteur situé entre deux régions d'accès dites alternativement source et drain ;
- gravure, à travers un masque, de la couche de silice et des couches la recouvrant de manière à rejoindre le noyau métallique ;
- élimination du masque ;
- recharge électrolytique des électrodes de drain et de source.

D'autres caractéristiques et avantages de la présente invention apparaîtront à la lecture de la description de différents modes de réalisation d'un transistor de puissance en matériau III-V sur substrat en silicium faite ci-après avec référence aux dessins ci-annexés dans lesquels :

- les figures 1, 2 et 3 sont des vues en coupe schématiques d'un transistor de puissance selon l'invention réalisé conformément au premier procédé de fabrication ;
- les figures 4a à 4g sont des vues en coupe schématiques des différentes étapes de réalisation d'un transistor de puissance selon le second procédé conforme à la présente invention.

La présente invention sera décrite en se référant à un transistor de puissance réalisé en arséniure de gallium sur un substrat en silicium. Toutefois, il est évident pour l'homme de l'art que la présente invention s'applique à tous les transistors de puissance fabriqués avec des matériaux rapides de la famille III-V tels que GaAs, GaAlAs, InP, GaInP, ... etc sur un substrat en silicium. D'autre part, dans les figures, on a réalisé une structure MESA. Toutefois, il est évident pour l'homme de l'art que la présente invention s'applique également aux transistors planars et aux circuits intégrés. D'autre part, pour simplifier la description, le transistor est schématisé par deux couches actives implantées dans une couche de GaAs semi-isolante et par ces trois métallisation de source, grille et drain. De plus, l'on n'a pas représenté sur la figure les différentes couches tampon qui permettent d'adapter le paramètre de mailles cristallines de GaAs au paramètre de mailles des couches de silicium, cette technique étant maintenant bien connue de l'homme de l'art.

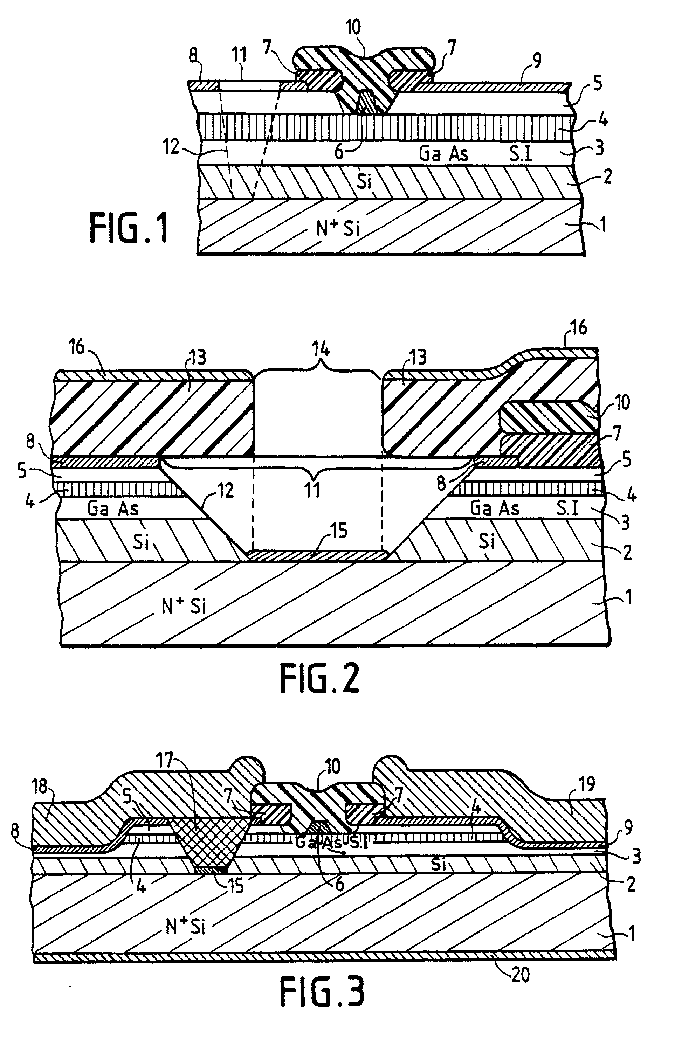

Sur la figure 1, on a représenté une vue en coupe de la plaquette de matériau semi-conducteur à l'étape précédant le perçage du puits nécessaire à la réalisation de la connexion entre une des régions d'accès du transistor, à savoir la source dans le mode de réalisation représenté, et le substrat en silicium. Comme représenté sur la figure 1, la plaquette de matériau semi-conducteur est constituée essentiellement par un substrat 1 en silicium qui est rendu électriquement conducteur par un dopage de type N + ou éventuellement P +. Ce substrat a une épaisseur d'en général 200 à 400 $\mu$m réduite à 50$\mu$m une fois fini. Sur le substrat 1, conformément à la présente invention, on a déposé par épitaxie une couche de silicium intrinsèque, à savoir du silicium présentant une résistivité de 10 000 $\Omega$/cm. Cette couche a été déposée en utilisant de préférence une technique d'épitaxie en phase vapeur et elle présente une épaisseur d'au moins 10 $\mu$m. Sur la couche tampon 2 en silicium intrinsèque a été déposée en utilisant une technique d'épitaxie telle qu'une épitaxie par jet moléculaire ou une épitaxie en phase vapeur d'organométallique (MOCVD), une couche 3 d'un matériau de la famille III-V semi-isolante, de préférence une couche d'arséniure de gallium GaAs. Cette couche 3 de GaAs a une épaisseur de 1 à 3,5 $\mu$m, elle est constituée par du GaAs semi-isolant, à savoir du GaAs qui n'est pas intentionnellement dopé, c'est-à-dire que son taux d'impureté est au niveau de $10^{14}$, $10^{15}$, AT.Cm$^{-3}$.

Sur cette couche 3, ont été épitaxiées ou implantées de manière connue une ou plusieurs couches qui constituent la couche active du transistor. Par exemple, on a déposé une première couche 4 de GaAs dopée de type N et une couche 5 de GaAs dopée de type N +. Ces couches ont une épaisseur d'environ 3000 Å pour la couche 4 et 1 500 Å pour la couche 5.

Des métallisations ont été réalisées en utilisant un procédé classique de fabrication d'un transistor de puissance. Ainsi, la région centrale supporte une métallisation de grille 6 réalisée, par exemple, en titane- aluminium. Cette métallisation 6 est recouverte par une couche de nitrure de silicium 10 qui s'appuie sur deux marches de silice 7, conformément au procédé classique de fabrication du transistor.

De part et d'autre de la grille 6 et de la région de canal, deux métallisations 8 et 9 ont été déposées sur les régions d'accès dites source et drain. Comme représenté sur la figure 1 et conformément à la présente invention, on a réalisé dans la métallisation d'accès 8 au transistor, à savoir la métallisation de source qui est en générale la plus chaude, une ouverture 11. Cette ouverture 11 est utilisée pour graver un puits 12 dans les couches 3,4,5 de GaAs et la couche 2 de silicium intrinsèque. Ce puits 12 est symbolisé par un pointillé sur la figure 2.

Comme représenté sur la figure 2, pour réaliser la gravure du puits 12, la plaquette est recouverte, du côté transistor, par une couche épaisse 13 de photorésist qui est ensuite masquée et développée de façon à créer une ouverture 14, concentrique à l'ouverture 11 dans la métallisation 8. L'ouverture 14 peut être plus petite en raison de la future sous-gravure. Les couches 5, 4, 3 de GaAs ainsi que la couche 2 de silicium intrinsèque sont alors gravées soit par une gravure chimique sélective au moyen d'une solution connue, soit par plasma de chlore dans le fréon. Cette gravure s'arrête au niveau du substrat en silicium 1. Le puits 12 présente en général des flancs inclinés à 45° par rapport au substrat. Ensuite, conformément à la présente invention, à travers l'ouverture 14, on dépose sur le substrat en silicium 1 une couche métallique, par exemple une couche de chrome et d'or, de manière à réaliser un contact ohmique 15. Cette couche est déposée par évaporation selon une méthode connue.

Pour réaliser un bon contact ohmique, la couche de chrome et d'or sera soumise à un recuit qui dans ce cas ne pourra être que d'au plus 400°C pour ne pas endommager les couches de GaAs.

Ensuite, de manière connue de l'homme de l'art, on dissout la couche épaisse de photorésist 13 par une opération dite de "lift-off" de manière à dégager la surface de la plaquette et par la même opération on supprime la couche 16 de Cr-Au qui s'est déposée sur la couche de résine 13 au cours de l'évaporation.

Le contact ohmique 15 sert alors, en combinaison avec le substrat conducteur 1 en silicium, à effectuer une recharge en or électrolytique dans le puits 12. Cette recharge est arrêtée lorsque le noyau métallique 17 ainsi créé est coplanaire avec la métallisation 8, comme représentée sur la figure 3. Une recharge finale en Ti-Pt-Au par évaporation des métallisations 8 et 9 de source et de drain complète le transistor selon l'invention comme représenté par les références 18 et 19. D'autre part, la face arrière du substrat 1 est métallisée pour réaliser l'électrode 20 d'accès à la source ou aux sources. De manière connue, avant dépôt de la métallisation 20, la face arrière du substrat en silicium peut être rodée de manière à diminuer l'épaisseur de la plaquette, ce qui diminue l'impédance thermique du substrat 1 et favorise le transfert de chaleur vers une embase métallique.

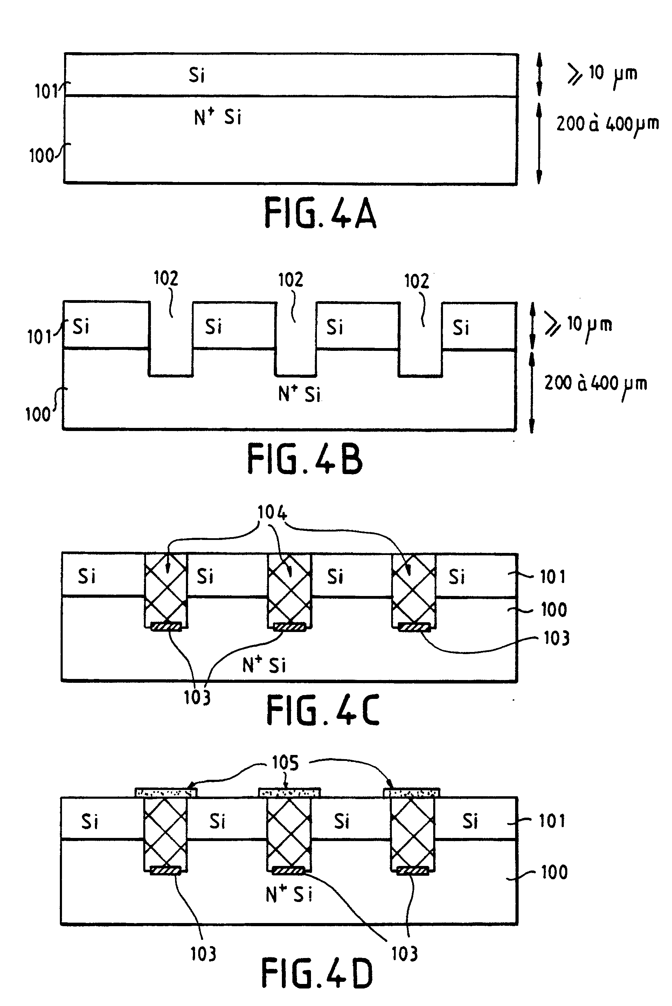

On décrira maintenant avec référence aux figures 4a à 4g, un procédé préférentiel de réalisation d'un transistor de puissance conforme à la présente invention.

Comme représenté sur la figure 4a, sur un substrat 100 en silicium dopé N+ pour le rendre conducteur, est déposée par épitaxie une couche 101 de silicium intrinsèque. On utilise de préférence un dépôt par épitaxie en phase vapeur. Comme représenté sur la figure 4a, le substrat 100 présente une épaisseur comprise entre 200 et 400μm et la couche tampon en silicium intrinsèque 101 présente une épaisseur supérieure à 10μm.

Comme représenté sur la figure 4b, on grave la couche tampon 101 en silicium intrinsèque. Cette gravure est effectuée à l'aide d'un masque dans lequel on a réalisé des ouvertures au niveau des électrodes de source du futur transistor. Cette gravure est réalisée, de préférence en utilisant une gravure plasma connue comme une gravure plasma RIE (pour réaction ion etching). Dans le fond des puits 102 ainsi réalisés, on dépose par évaporation une couche 103 métallique, par exemple une couche chrome-or, pour réaliser un contact ohmique sur le substrat en silicium 100. Pour obtenir un bon contact ohmique sur le silicium, on effectue un recuit en général à des températures supérieures à 450°C.

Ensuite, comme représenté sur la figure 4c, on planarise les puits 102 en réalisant une recharge des puits avec de l'or électrolytique comme représenté par la référence 104.

Comme représenté sur la figure 4d, on dépose alors sur l'ensemble de la plaquette une couche de silice présentant une épaisseur d'environ 3000 Å. Puis, à l'aide d'un masque, on attaque cette couche de silice sauf aux emplacements des futures sources de manière à obtenir des pavés de silice 105.

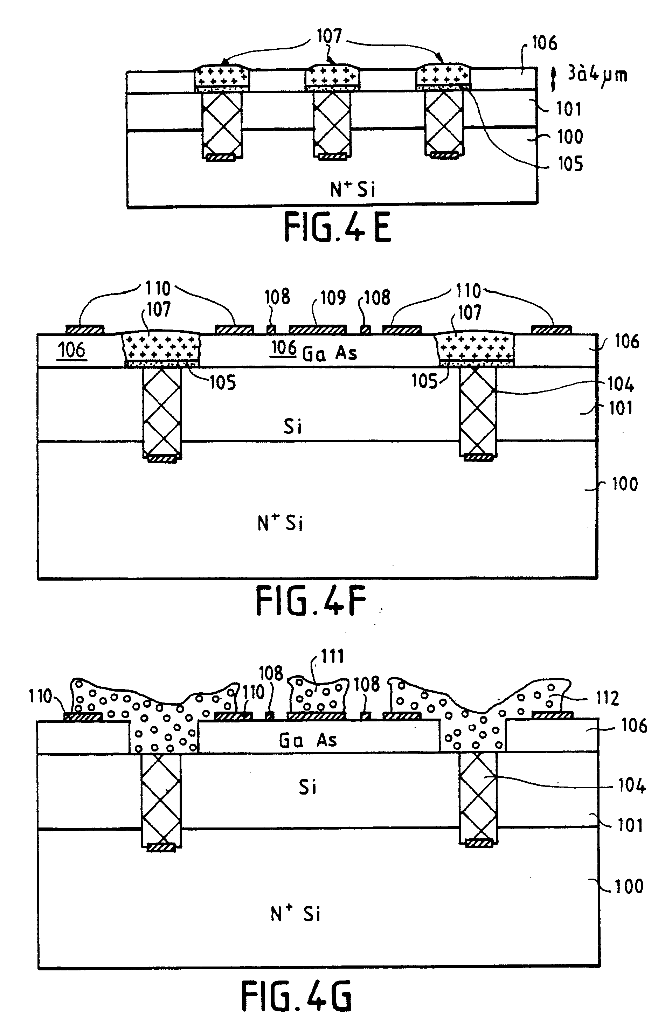

Ensuite, comme représenté sur la figure 4e, on dépose par épitaxie une couche 106 d'arséniure de gallium semi-isolante sur la plaquette. On utilise dans ce cas, de préférence une épitaxie par jet moléculaire ou une épitaxie en phase vapeur d'organo-métalliques (MOCVD). Suite à ce dépôt d'arséniure de gallium, on obtient, aux endroits où se trouve la couche de silicium intrinsèque, une couche 106 d'arséniure de gallium monocristallin de bonne qualité dans laquelle on réalise les électrodes de drain et de grille. Aux endroits où se trouvent les pavés de silice 105, on obtient soit une couche 108 d'AsGa polycristallin, soit aucun dépôt lorsque l'on utilise une épitaxie sélective par exemple par modulation de flux. La couche d'AsGa monocristallin présente une épaisseur d'environ 3 à 4μm. Ensuite, en utilisant un procédé classique de fabrication d'un transistor à effet de champs, on réalise sur l'AsGa monocristallin les métallisations de grille 108 en Ti-Al et les métallisations de drain 109 et de source 110 avec une superposition de couches métalliques telles que Au-Ge-Ni-Au.

Comme représenté sur la figure 4f, deux métallisations de source 110 entourent chaque puits 102.

Ensuite, comme représenté sur la figure 4g, on attaque de manière connue les couches d'AsGa polycristrallin et de silice pour rejoindre l'or électrolytique ayant rechargé les puits 102. On réalise ensuite, de manière connue une recharge des plots de drain et de source en Ti-Pt-Au de manière à achever le processus de fabrication de ce transistor. Puis, comme dans le premier procédé de fabrication, on peut réaliser un rodage de la face arrière du substrat conducteur en silicium et déposer une métallisation non représentée réalisant une électrode d'accès aux sources.

Comme mentionné ci-dessus, l'un des avantages de ce procédé réside dans le fait que le contact ohmique sur le substrat en silicium conducteur est réalisé avant le dépôt par épitaxie d'AsGa, c'est-à-dire avant toute étape technologique sur l'arséniure de gallium. Il est donc possible de recuire le contact ohmique sur silicium à des températures supérieures à 400°C, ce qui permet d'optimiser les contacts ohmiques avec le silicium. D'autre part, le procédé de fabrication des figures 4a à 4g illustre la fabrication d'un transistor de puissance à structure grille interdigitée.

On rappellera ci-après l'ensemble des avantages de ce nouveau transistor de puissance en matériau de la famille III-V sur un substrat en silicium. Ce nouveau transistor présente une dissipation thermique optimisée par rapport au transistor réalisé sur un substrat en arséniure de gallium, ce qui permet de réaliser des transistors de puissance. De plus, l'utilisation d'une couche tampon en silicium intrinsèque permet de diminuer les capacités grille-source et drain-source par rapport au transistor décrit dans la demande de brevet française N°88 13155. Cette diminution des capacités entraîne une amélioration sensible au niveau des performances hyperfréquences. On obtient de plus une diminution des fuites de courant drain-source puisqu'on réalise une couche tampon épaisse constituée par une couche d'arséniure de gallium semi-isolante d'environ 2 μm associée à une couche tampon en silicium intrinsèque d'au moins 10μm. Cette diminution des fuites de courant drain-source permet la polarisation du transistor à des tensions drain-source plus élevées. En conséquence, le transistor peut fournir une puissance plus élevée. D'autre part, le transistor est réalisé en utilisant une technique entièrement face avant ce qui améliore le rendement de fabrication.

## Revendications

1.  Transistor de puissance en matériaux de la famille III-V sur silicium du type comportant un substrat (1) en silicium, au moins une couche (3) de matériau III-V semi-isolant et une pluralité de couches (4,5) de matériau III-V dopées dans lesquelles est défini aux moins un canal conducteur muni d'une métallisation (6) de grille, chaque canal étant situé entre deux régions d'accès dites alternativement source et drain, munies chacune d'une métallisation (8,9), l'une des deux régions d'accès à un canal étant connectée électriquement et thermiquement avec le substrat en silicium, caractérisé en ce qu'il comporte entre le substrat en silicium et la couche de matériau III-V semi-isolant, au moins une couche tampon (2) de silicium intrinsèque.

2. Transistor selon la revendication 1, caractérisé en ce que la couche tampon de silicium présente une épaisseur supérieure ou égale à 10 $\mu$m.

3. Transistor selon l'une quelconque des revendications 1 et 2, caractérisé en ce que le substrat est en silicium dopé $N^+$ ou $P^+$.

4. Transistor selon l'une quelconque des revendications 1 à 3, caractérisé en ce que l'interconnexion entre une des régions d'accès et le substrat en silicium est réalisée par un noyau métallique (17) qui traverse les couches de matériau III-V et de silicium intrinsèque et prend un contact ohmique (15) sur le substrat au niveau de l'interface avec la couche de silicium intrinsèque.

5. Transistor selon l'une quelconque des revendications 1 à 4, caractérisé en ce que les matériaux III-V sont constitués par des composés binaires ou ternaires entre Ga, As, Al, In,P.

6. Procédé de fabrication d'un transistor de puissance selon l'une quelconque des revendications 1 à 5, caractérisé en ce qu'il comporte les étapes suivantes :
   - dépôt par épitaxie sur un substrat (1) en silicium d'une couche tampon (2) en silicium intrinsèque ;
   - dépôt par épitaxie sur la couche tampon d'au moins une couche (3) d'un matériau de la famille III-V semi-isolant ;
   - réalisation de manière connue sur la couche en matériau semi-isolant d'un transistor de puissance contenant au moins un canal conducteur situé entre deux régions d'accès dite alternativement source et drain ;
   - réalisation d'au moins une ouverture (11) dans la métallisation de prise de contact de l'une des deux régions d'accès, source ou drain ;
   - gravure, à travers cette ou ces ouvertures et au moyen d'un masque, des couches de matériau III-V et de silicium intrinsèque, la gravure s'arrêtant au contact du substrat en silicium ;
   - dépôt, dans le fond du ou des puits obtenus, d'une couche métallique assurant un contact ohmique (15) avec le substrat en silicium ;
   - élimination du masque et
   - recharge électrolytique du ou des puits en métal jusqu'à ce que le noyau métallique (17) formé soit, coplanaire avec la métallisation de la région dans laquelle il est forme.

7. Procédé de fabrication d'un transistor de puissance selon l'une quelconque des revendications 1 à 5, caractérisé en ce qu il comporte les étapes suivantes :
   - dépôt par épitaxie sur un substrat (100) en silicium d'une couche tampon (101) en silicium intrinsèque ;
   - réalisation à l'aide d'un masque d'au moins une ouverture au niveau des futures électrodes d'un type des deux régions d'accès source ou drain ;
   - gravure à travers cette ou ces ouvertures de la couche tampon en silicium intrinsèque, la gravure s'arrêtant au contact du substrat en silicium ;
   - dépôt dans le fond du ou des puits (102) obtenus, d'une couche métallique (103) assurant un contact ohmique avec le substrat en silicium ;
   - élimination du masque ;
   - recharge électrolytique du ou des puits en métal jusqu'à ce que le noyau métallique (104) formé soit coplanaire avec la couche tampon ;
   - dépôt sur l'ensemble de la plaquette d'une couche de silice ;
   - gravure, à travers un masque recouvrant les régions d'accès ci-dessus, de la couche de silice jusqu'au niveau de la couche tampon et élimination du masque ;
   - dépôt par épitaxie sur l'ensemble de la plaquette, d'au moins une couche (106) de matériau III-V semi-isolant donnant, au-dessus de la couche tampon, une couche de matériau III-V monocristalline ;
   - réalisation, de manière connue, sur la couche monocristalline d'un transistor de puissance contenant au moins un canal conducteur situé entre deux régions d'accès dites alternativement source et drain ;
- gravure, à travers un masque, de la couche de silice et des couches la recouvrant de manière à rejoindre le noyau métallique ;
- élimination du masque ;
- recharge électrolytique des électrodes de drain et de source ;

8. Procédé selon les revendications 6 ou 7, caractérisé en ce que l'épitaxie de la couche tampon est une épitaxie en phase vapeur ;

9. Procédé selon les revendications 6 ou 7, caractérisé en ce que l'épitaxie des couches de matériau III-V est une épitaxie par jet moléculaire ou épitaxie en phase vapeur d'organo-métalliques (MOCVD).

10. Procédé selon les revendications 6 ou 7, caractérisé en ce que la gravure du ou des puits est une gravure sélective soit chimique, soit physique par attaque plasma à base de chlore.

FIG.1

FIG.2

FIG.3

Si

101

N⁺ Si

100

≫ 10 μm

200 à 400μm

## FIG.4A

102          102          102

Si          Si          Si          Si

101

N⁺ Si

100

≫ 10 μm

200 à 400 μm

## FIG.4B

104

Si          Si          Si          Si          101

100

N⁺ Si          103

103          FIG.4C

105

Si          Si          Si          Si          101

N⁺ Si          100

103          103

## FIG.4D

FIG.4E

FIG.4F

FIG.4G

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| Y | PATENT ABSTRACTS OF JAPAN vol. 10, no. 192 (E-417)(2248) 05 juillet 1986, & JP-A-61 39581 (OKI ELECTRIC IND CO LTD) 25 février 1986, * le document en entier * | 1, 3, 5 | H01L23/36 H01L29/267 H01L29/52 H01L21/74 H01L21/205 |
| Y | FR-A-2464562 (THOMSON-CSF) * page 3, ligne 11 - page 4, ligne 13; figures 3, 4, 7 * * page 5, lignes 6 - 19 * | 1, 3, 5 | |
| A | FR-A-2207401 (COMPAGNIE INTERNATIONALE POUR L'INFORMATIQUE) * page 2, lignes 6 - 15; figures 1, 2 * | 6, 7 | |
| A | FR-A-2026315 (TEXAS INSTRUMENTS INCORPORATED) * le document en entier * | 1, 4, 5 | |
| A | IEEE TRANSACTIONS ON MICROWAVE THEORY AND TECHNIQUES. vol. MTT32, no. 3, mars 1984, NEW YORK US pages 309 - 316; YASUTAKE HIRACHI ET AL: "A Packaged 20-GHz 1-W GaAs MESFET with a Novel Via-Hole Plated Heat Sink Structure." * abrégé; figure 2 * | 1, 4, 5 | DOMAINES TECHNIQUES RECHERCHES (Int. Cl.5 ) H01L |
| A | JAPANESE JOURNAL OF APPLIED PHYSICS. vol. 23, no. 12, décembre 1984, TOKYO JP pages L919 - L921; Toshio_Nonaka et al: "Fabrication of GaAs MESFET Ring Osillator on MOCVD Grown GaAs/Si(100) Substrate" * abrégé; figure 1 * | 9 | |
| A | JOURNAL OF VACUUM SCIENCE AND TECHNOLOGY: PART A.may-june 1985 vol. 3, no. 3, NEW YORK US pages 863 - 866; A.E. Geissberger et al: "Application of plasma etching to via hole fabrication in thick GaAs substrates" * abrégé * | 10 | |

Le présent rapport a été établi pour toutes les revendications

| Lieu de la recherche | Date d'achèvement de la recherche | Examinateur |
|---|---|---|
| LA HAYE | 21 FEVRIER 1991 | MIMOUN B.J. |

Office européen  **RAPPORT DE RECHERCHE EUROPEENNE**

des brevets

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|-----------|-------------------------------------------------------------------------------|------------------------|--------------------------------------|
| | — — — — | | |

DOMAINES TECHNIQUES
RECHERCHES (Int. Cl.5)

Le présent rapport a été établi pour toutes les revendications

| Lieu de la recherche | Date d'achèvement de la recherche | Examinateur |
|----------------------|-----------------------------------|-------------|
| LA HAYE | 21 FEVRIER 1991 | MIMOUN B.J. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

                              
& : membre de la même famille, document correspondant

EPO FORM 1503 03.82 (P0402)